# EUROPEAN PATENT APPLICATION

(11) **EP 4 841 392 A1**
(43) Date of publication of application: **18.11.2026**
(21) Application number: 25770214.2
(22) Date of filing: 02.09.2025
(51) Int. Cl.: G06F 1/186, H05K 7/14

(54) **SERVER EXPANSION CARD FIXING MECHANISM AND SERVER**

(30) Priority: 31.03.2025 CN 202510396367
(71) Applicant: Suzhou Metabrain Intelligent Technology Co., Ltd., Suzhou, Jiangsu 215000 (CN)
(72) Inventor: NIU, Zhanlin, Suzhou, Jiangsu 215000 (CN)
(74) Representative: Studio Torta S.p.A.
(86) International application number: PCT/CN2025/118538
(87) International publication number: WO 2026/208077

(57) **Abstract**

Some embodiments of the disclosed are an expansion card fixing mechanism and a server, which relate to a technical field of servers. The server expansion card fixing mechanism includes: a bracket; and a fixing structure connected with the bracket or a chassis of a server, the fixing structure having at least two slots, a card accommodation space being formed between the fixing structure and the bracket or the chassis, and a size of the card accommodation space being adjustably configured to allow an expansion card to be positioned within one of the at least two slots. The present invention effectively solves the problem in the related art that an expansion card of a server is prone to loosening, resulting in poor fixing performance.

## Description

### Cross-Reference to Related Application

The present invention claims priority to Chinese Patent Application No. 202510396367.8, filed to the China National Intellectual Property Administration on March 31, 2025 and entitled "Server Expansion Card Fixing Mechanism and Server", which is incorporated herein by reference in its entirety.

### Technical Field

The present invention relates to a technical field of servers, and in particular, to a server expansion card fixing mechanism and a server.

### Background

In the current server hardware design, a Peripheral Component Interconnect Express (PCIe) card, serving as a critical expansion component, has a fixing manner inside the server that is crucial to the stability and reliability of the system.

In the related art, the PCIe cards of most servers relies only on planar contact fixing; however, the fixing manner lacks effective mechanical locking, which may cause the PCIe cards to loosen during transportation or under vibration and impact, thereby affecting the normal operation of the servers.

### Summary

Some embodiments of the present invention provide a server expansion card fixing mechanism and a server, so as to at least solve the problem in the related art that an expansion card of the server is prone to loosening, resulting in poor fixing performance.

According to a first aspect, the present invention provides a server expansion card fixing mechanism, including: a bracket; and a fixing structure connected to the bracket or a chassis of a server, the fixing structure having at least two slots, a card accommodation space being formed among the fixing structure, the bracket and the chassis, and a size of the card accommodation space being adjustably configured to allow an expansion card to be positioned within one of the at least two slots.

In some embodiments, the bracket includes a plurality of first mating portions arranged at intervals along a preset direction, and the fixing structure comprises: a first plate body slidably arranged on the bracket in the preset direction, a second mating portion being arranged on the first plate body, and the second mating portion selectively mates with at least one of the first mating portions; and a second plate body connected with the first plate body and arranged at an angle, the slots being arranged on the second plate body.

In some embodiments, the first plate body includes: a first plate segment having two grooves spaced apart from each other; a second plate segment located between the two grooves, both ends of the second plate segment being connected to the first plate segment; and the second mating portion is arranged on the second plate segment; and/or a first reinforcing rib disposed on the second plate segment and spaced apart from the second mating portion.

In some embodiments, the second mating portion has an inclined guide face; and/or the second plate body is provided with a second reinforcing rib.

In some embodiments, the server expansion card fixing mechanism further includes: a locking assembly connected with the bracket, the locking assembly including a movably arranged locking portion, and the locking portion being used for locking or unlocking the positioning portion of the chassis.

In some embodiments, the bracket includes a third mating portion, and the locking assembly further includes: a locking body; a positioning structure arranged on the locking body so as to be in limiting fit with the bracket; a fourth mating portion, arranged on the locking body, the third mating portion limiting fit with the fourth mating portions; and/or the locking body includes a connecting hole, and the locking assembly further includes a fastener, so as to connect the bracket and the locking body by passing through the connecting hole and the bracket.

In some embodiments, the locking body includes: a first handle, the locking portion being arranged on a first end of the first handle; and the first handle is rotatable so as to drive the locking portion to be in limiting fit with or separated from the positioning portion.

In some embodiments, the locking body includes: a guide sleeve movably sleeved outside the positioning portion; a body portion arranged on the guide sleeve, the third mating portion and the positioning structure and/or the connecting hole being arranged on the body portion; a second handle arranged on the guide sleeve; a connecting arm, two ends of the connecting arm being respectively connected to the first handle and the second handle; and wherein in the process of operating a second end of the first handle to rotate around the connecting arm, the first handle drives the locking portion to move.

In some embodiments, the positioning portion has a flange, the locking portion has an extension plate, and the extension plate is used for extending between the flange and the chassis so as to limit fit with the flange

In some embodiments, the locking assembly further includes: a stop structure located between the second handle and the first handle; and in a process of the first handle rotating around the connecting arm, the stop structure is used for limiting fit with the first handle.

In some embodiments, the bracket includes a bracket body and a window body provided on the bracket body; and the server expansion card fixing mechanism further includes: a retaining plate, the retaining plate being provided on an inner side of the window body for limiting fit with the expansion card.

In some embodiments, the window body is provided with a first protrusion, and the retaining plate is provided with a first recess, the first protrusion extending into the first recess so as to limit fit with the first recesses.

In some embodiments, the server expansion card fixing mechanism further includes: a clamping structure rotatably connected to the window body or the bracket body for pressing against the retaining plate.

In some embodiments, the clamping structure includes: a clamping body; an extension arm provided on the clamping body, the extension arm extending along a width direction of the retaining plate so as to press against the retaining plate; there is one or more extension arms, and when there are a plurality of extension arms, the plurality of extension arms are arranged at intervals along the width direction of the retaining plate and/or a width direction of the clamping body.

In some embodiments, when the clamping structure presses against the retaining plate, a surface of the clamping body facing away from the retaining plate forms a mounting surface; and the clamping structure further includes: metal sheets covering at least a portion of the mounting surface.

In some embodiments, the first protrusion is provided with mounting holes, and the clamping structure includes: a clamping body; protruding posts are provided on the clamping body; when the clamping structure presses against the retaining plate, the protruding post extend into the mounting hole and is in limiting fit with the mounting hole.

In some embodiments, the clamping body is in a plate shape, and when the clamping structure presses against the retaining plate, two ends of the clamping body respectively limit fit with the bracket body and the window body.

In some embodiments, the clamping structure further includes a third plate body and an extension plate body; the third plate body is rotatably connected with the window body, and the extension plate body is connected with one end of the third plate body and is disposed at an angle relative to the third plate body; the extension plate body includes a third plate segment and a fourth plate segment connected with each other; the fourth plate segment is connected withto the third plate body by the third plate segment, the third plate segment and the fourth plate segment are disposed at an obtuse angle, and the third plate body and the fourth plate segment are disposed on two sides of the third plate segment respectively.

In some embodiments, the window body is provided with a second protrusion, so that when the clamping structure is in a first position, the second protrusion is located outside the third plate to limit fit with the third plate body.

According to a second aspect, the present invention further provides a server, including: a chassis, including a positioning portion; a motherboard, arranged in the chassis; an expansion card; a server expansion card fixing mechanism, which is configured to mount the expansion card so as to fix the expansion card on the chassis; and the server expansion card fixing mechanism is the described server expansion card fixing mechanism.

In the technical solution of the present invention, the server expansion card fixing mechanism includes a bracket and a fixing structure, the fixing structure is connected to the bracket or a chassis of a server, the fixing structure has at least two slots, a card accommodation space is formed between the fixing structure and the bracket or the chassis, and the size of the card accommodation space is adjustably configured to allow an expansion card to be positioned within one of the slots. In this way, the connection between the fixing structure and the bracket or the server chassis ensures the stability of the expansion card inside the server, prevents poor contact or damage to the expansion card due to displacement, and ensures stable operation and data security of the server, thereby solving the problem in the related art that an expansion card of a server is prone to loosening, resulting in poor fixing performance. Moreover, the design of at least two slots on the fixing structure and the adjustable characteristic of the card accommodation space enable the server expansion card fixing mechanism to be adapted to expansion cards of different specifications, including half-height cards and full-height cards, thereby improving the configuration flexibility and extensibility of the server, and satisfying the requirements of different application scenarios.

Compared with the planar contact fixing method used in related art to fix an expansion card, the expansion card fixing mechanism of the present invention, by means of the innovative structural design, not only enhances the fixing stability and compatibility of the expansion card, but also simplifies the installation and maintenance process of the expansion card, reducing the maintenance cost of a server, and improving the device reliability and user satisfaction.

### Brief Description of the Drawings

In order to better illustrate the technical solutions in the embodiments of the present invention, the figures used in the description of the embodiments will be briefly introduced below; it is obvious that the figures mentioned in the following description only show some embodiments of the present invention, and a person skilled in the art would be able to obtain further figures on the basis of these figures without any inventive effort.
Fig. 1 illustrates a three-dimensional structural diagram of a server provided according to embodiment 1 of the present invention;
Fig. 2 illustrates a schematic three-dimensional structural diagram of a server expansion card fixing mechanism and an expansion card after being assembled (in a full-height card configuration) provided according to embodiment 1 of the present invention;
Fig. 3 illustrates a schematic enlarged diagram of the expansion card fixing mechanism at part A in Fig. 2;
Fig. 4 illustrates a schematic three-dimensional structural diagram of a server expansion card fixing mechanism and an expansion card after being assembled (in a half-height card configuration) provided according to embodiment 1 of the present invention;
Fig. 5 illustrates a schematic three-dimensional structural diagram of a server expansion card fixing mechanism provided according to embodiment 1 of the present invention;
Fig. 6 illustrates an exploded view of the server expansion card fixing mechanism in Fig. 5;
Fig. 7 illustrates a schematic three-dimensional structural diagram of a locking assembly of the server expansion card fixing mechanism in Fig. 5;
Fig. 8 illustrates a schematic three-dimensional structural diagram of the locking assembly in Fig. 7 from another angle;
Fig. 9 illustrates a schematic three-dimensional structural diagram of a fixing structure of the server expansion card fixing mechanism in Fig. 5;
Fig. 10 illustrates a schematic three-dimensional structural diagram of the fixing structure in Fig. 9 from another angle;
Fig. 11 illustrates a schematic three-dimensional structural diagram of a clamping structure of the server expansion card fixing mechanism in Fig. 5 in a first position;
Fig. 12 illustrates a schematic three-dimensional structural diagram of the clamping structure of the server expansion card fixing mechanism in Fig. 5 in a second position;
Fig. 13 illustrates a schematic three-dimensional structural diagram of the clamping structure of the server expansion card fixing mechanism in Fig. 5;
Fig. 14 illustrates a schematic three-dimensional structural diagram of a server expansion card fixing mechanism provided according to embodiment 2 of the present invention;
Fig. 15 illustrates a schematic three-dimensional structural diagram of the server expansion card fixing mechanism in Fig. 14 at a first angle;
Fig. 16 illustrates a schematic three-dimensional structural diagram of the server expansion card fixing mechanism in Fig. 14 at a second angle; and
Fig. 17 illustrates a partially enlarged view of the clamping structure, the retaining plate, and the bracket of the server expansion card fixing mechanism in Fig. 14 after being assembled.

The figures above include the following reference signs:
10. bracket; 11. card mounting port; 12. first mating portion; 13. third mating portion; 14. bracket body; 141. fifth mating portion;15. window body; 151. mounting hole; 152. first protrusion; 153. second protrusion;
20. locking assembly; 21. locking body; 211. connecting hole; 212. guide sleeve; 213. body portion; 214. second handle; 215. connecting arm; 216. first handle; 217. stop structure; 22. locking portion; 221. extension plate; 23. positioning structure; 24. fourth mating portion; 25. fastener;
30. chassis; 31. positioning portion; 311. flange;
40. fixing structure; 41. card accommodation space; 42. first plate body; 421. second mating portion; 4211. inclined guide surface; 422. first plate segment; 4221. groove; 423. second plate segment; 424. first reinforcing rib; 43. second plate body; 431. slot; 432. second reinforcing rib;
50. clamping structure; 51. sixth mating portion; 52. third plate body; 53. extension plate body; 531. third plate segment; 532. fourth plate segment; 54. protruding post; 55. clamping body; 56. extension arm; 57. metal sheet; 60. expansion card; 70. motherboard; 80. retaining plate.

### Detailed Description of the Embodiments

Hereinafter, the technical solutions in the embodiments of the present invention will be described clearly and completely with reference to the accompanying drawings of the embodiments of the present invention. Obviously, the embodiments as described are only some of the embodiments of the present invention, and are not all of the embodiments. On the basis of the embodiments of the present invention, all other embodiments obtained by a person of ordinary skill in the art without any inventive effort shall all fall within the scope of protection of the present invention.

It should be noted that orientation or positional relationships indicated by the terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial" and "circumferential" are orientation or positional relationships based on the accompanying drawings, are only used to facilitate the illustration of the present invention and to simplify the illustration, rather than indicating or implying that an apparatus or element referred to must have a specific orientation, and be constructed and operated in the specific orientation, and therefore said terms cannot be understood as limitation to the present invention. The terms "mount", "connect to", "connect" should be understood broadly, and for example, may be fixed connection, and may also be detachable connection, or integral connection; may be mechanical connection, and may also be electrical connection; and may be direct connection, and may also be indirect connection by means of an intermediate medium, and may also be interior communication between two elements. The terms "parallel", "perpendicular", and "equal" include the cases illustrated and similar to the cases illustrated, the range of which is within an acceptable range of deviation as determined by a person of ordinary skill in the art in view of the measurement in question and the error (i.e., the limitations of a measurement system) associated with the measurement of a particular quantity. For example, "parallel" includes absolutely and approximately parallel, where an acceptable range of deviation from approximately parallel may be, for example, within 5° of deviation; and "perpendicular" includes absolute and approximately perpendicular, where an acceptable range of deviation from approximately perpendicular may also be, for example, within 5° of deviation. "Equal" includes absolutely and approximately equal, where an acceptable range of deviation from approximately equal may be that, for example, the difference between the two being equal is less than or equal to 5% of either. For a person of ordinary skill in the art, the specific meanings of the described terms in the present invention could be understood according to specific situations.

To make a person skilled in the art better understand the solutions of the present invention, hereinafter, the present invention is further described in detail with reference to the accompanying drawings and the specific embodiments.

In order to solve the problem in the related art that an expansion card of a server is prone to loosening, resulting in poor fixing performance, the present invention provides a server expansion card fixing mechanism and a server.

### Embodiment 1

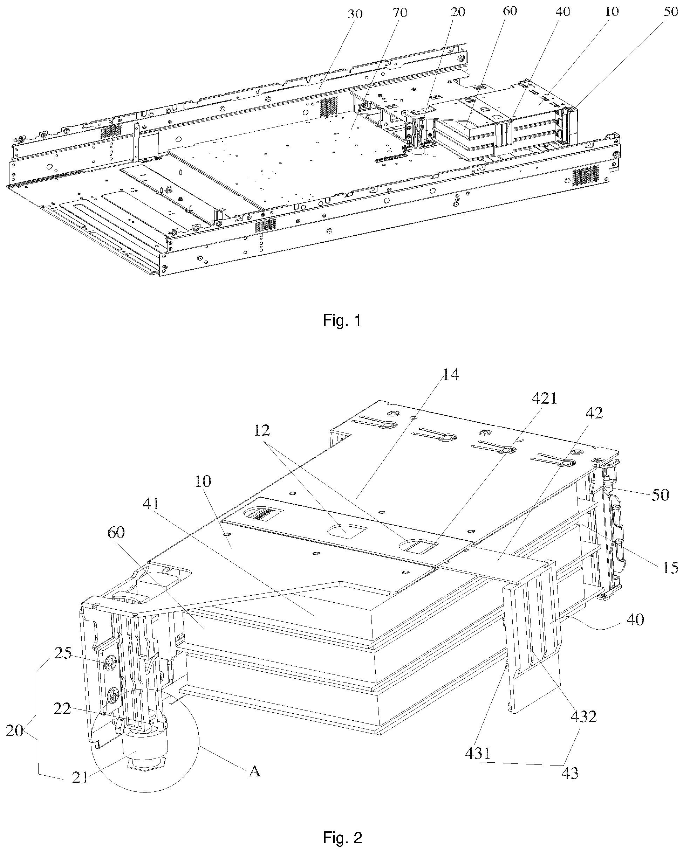

As shown in Figs. 1 to 13, the server expansion card fixing mechanism includes a bracket 10 and a fixing structure 40. The fixing structure 40 is connected to the bracket 10, the fixing structure 40 has at least two slots 431, a card accommodation space 41 is formed among the fixing structure 40, the bracket 10 and the chassis 30, and a size of the card accommodation space 41 is adjustably configured to allow an expansion card to be positioned within one of the at least two slots 431.

By applying the technical solution of this embodiment, the connection between the fixing structure 40 and the bracket 10 ensures the stability of the expansion card 60 inside the server, prevents poor contact or damage to the expansion card 60 due to displacement, and ensures stable operation and data security of the server, thereby solving the problem in the related art that an expansion card of a server is prone to loosening, resulting in poor fixing performance. Moreover, the design of at least two slots 431 on the fixing structure 40 and the adjustable characteristic of the card accommodation space 41 enable the server expansion card fixing mechanism to be adapted to expansion cards 60 of different specifications, including half-height cards and full-height cards, thereby improving the configuration flexibility and extensibility of the server, and satisfying the requirements of different application scenarios.

Compared with the planar contact fixing method used in related art to fix an expansion card, the expansion card fixing mechanism of the present embodiment, by means of the innovative structural design, not only enhances the fixing stability and compatibility of the expansion card, but also simplifies the installation and maintenance process of the expansion card, reducing the maintenance cost of a server, and improving the device reliability and user satisfaction.

In other embodiments not shown in the drawings, the fixing structure is connected with a chassis of the server. In this way, the connection between the fixing structure and the server chassis ensures the stability of the expansion card inside the server, prevents poor contact or damage to the expansion card due to displacement, and ensures stable operation and data security of the server, thereby solving the problem in the related art that an expansion card of a server is prone to loosening, resulting in poor fixing performance. Moreover, the configurations above enable the connection position of the fixing structure to be more flexible, so as to satisfy different usage requirements and working conditions, and also improve the working flexibility for workers.

In some embodiments, the expansion card 60 is a PCIe card.

As shown in Figs. 2, 4, 5, 9 and 10, the bracket 10 includes a plurality of first mating portions 12 arranged at intervals along a preset direction, and the fixing structure 40 includes a first plate body 42 and a second plate body 43. The first plate body 42 is slidably arranged on the bracket 10 in the preset direction, the first plate body 42 is provided with a second mating portion 421, and the second mating portion 421 selectively mates with the at least one of first mating portions 12. The second plate body 43 is connected with the first plate body 42 and arranged at an angle, and the slots 431 are arranged on the second plate body 43. In this way, the bracket 10 is provided with a plurality of first mating portions 12 arranged at intervals in a preset direction, so that the first plate 42 can stably cooperate with the bracket 10 at a plurality of positions, thereby adapting to expansion cards 60 of different lengths and positions, and further enabling the server to flexibly support a variable expansion card layout, thereby expanding the device configuration capability.

In some embodiments, one of the first mating portions 12 and the second mating portion 421 is a protrusion, and the other of the first mating portions 12 and the second mating portion 421 is a recess; and the protrusion can selectively extend into at least one recess so as to be in limiting fit with the recess. In this way, the mating mechanism of the protrusion and the recess provides an accurate positioning and firm fixing effect, and ensures that the expansion card is firmly mounted in the slot 431 formed by the first plate body 42 and the second plate body 43, thereby reducing the problem of poor contact or displacement of the expansion card caused by factors such as vibration and thermal expansion and cold contraction, and enhancing the system reliability and stability. Moreover, as the first plate body 42 can slide along the preset direction, a user can easily adjust, without using any tools, the position of the fixing structure 40 to adapt to the installation or replacement of different expansion cards 60, thereby simplifying the maintenance operation and enhancing the maintenance efficiency.

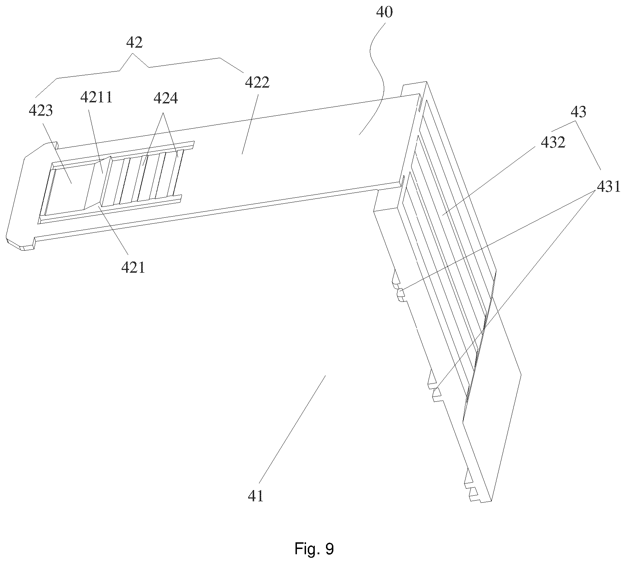

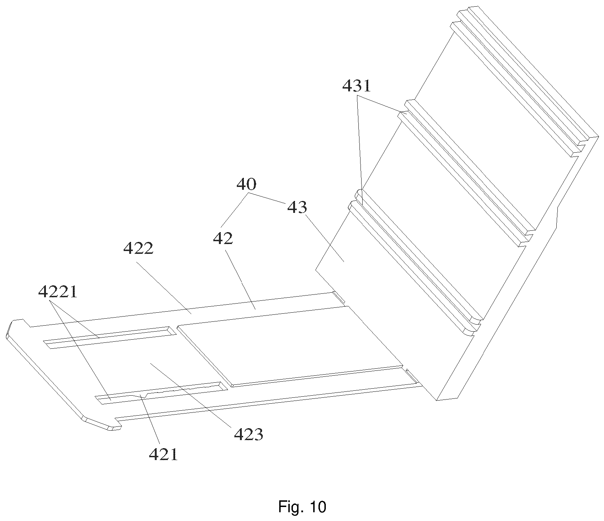

As shown in Figs. 9 and 10, the first plate body 42 includes a first plate segment 422 and a second plate segment 423. The first plate segment 422 includes two grooves 4221 spaced apart from each other, the second plate segment 423 is located between the two grooves 4221, and both ends of the second plate segment 423 are connected with the first plate segment 422; and the second mating portion 421 is provided on the second plate segment 423. And/or the first plate body 42 includes a first reinforcing rib 424 arranged on the second plate segment 423 and spaced apart from the second mating portion 421. In this way, the first plate body 42 adopts a segmented design including a first plate segment 422 and a second plate segment 423, wherein the second plate segment 423 is embedded between two grooves 4221 of the first plate segment 422. This design enables deformation of the second mating portion 421 while ensuring the overall rigidity of the first plate body 42, thereby allowing the first mating portions 12 and the second mating portion 421 to be engaged or disengaged from each other. It also prevents unnecessary deformation during sliding or fixing, ensuring the durability and long-term stability of the expansion card fixing mechanism.

In this embodiment, the first plate body 42 includes a first plate segment 422, a second plate segment 423 and first reinforcing rib 424. The second mating portion 421 arranged on the second plate segment 423 forms an interlocking structure with the first mating portions 12 of the bracket 10. By means of the fitting of the first protrusion and the first recess, the position of the first plate body 42 can be precisely adjusted, so as to ensure that the expansion card can be accurately mounted at a preset position. In addition, the design of the grooves 4221 does not affect the sliding performance, thereby improving the mounting precision and the fixing efficiency of the expansion card. Moreover, the arrangement of the first reinforcing rib 424 further enhances the structural strength and stability of the second plate segment 423, avoiding the abrasion or fatigue that may be generated during repeated sliding. The first reinforcing rib 424 and the second mating portion 421 are spaced apart from each other to distribute the force acting on the second plate segment 423, thereby ensuring the precision and functional integrity of the second mating portion 421 in long-term use.

In some embodiments, the second mating portion 421 has an inclined guide surface 4211; and/or the second plate body 43 is provided with a second reinforcing rib 432. In this way, in the process of disassembly and assembly the first protrusion and the first recess, the inclined guide surface 4211 provides a smooth guide function, effectively reducing friction between the two, and avoiding damage to the first protrusion and the first recess during assembly or disassembly. The arrangement of the second reinforcing rib 432 significantly enhances the structural strength and rigidity of the second plate body 43, thus preventing deformation of the second plate body 43 during the fixing process, and ensuring long-term stability and reliability of the fixing structure.

In this embodiment, the second mating portion 421 has an inclined guide surface 4211, and the second plate body 43 is provided with a second reinforcing rib 432.

As shown in Figs. 1, 2, 4 and 6, the server expansion card fixing mechanism further includes a locking assembly 20. The locking assembly 20 is connected with the bracket 10, the locking assembly 20 includes a movably arranged locking portion 22, and the locking portion 22 is used for locking or unlocking with a positioning portion 31 of the chassis 30. In this way, the bracket 10 may be locked or unlocked with the chassis 30 by means of the locking assembly 20, so as to improve the convenience of assembly and disassembly of the two without using tools, thereby greatly improving the server maintenance efficiency.

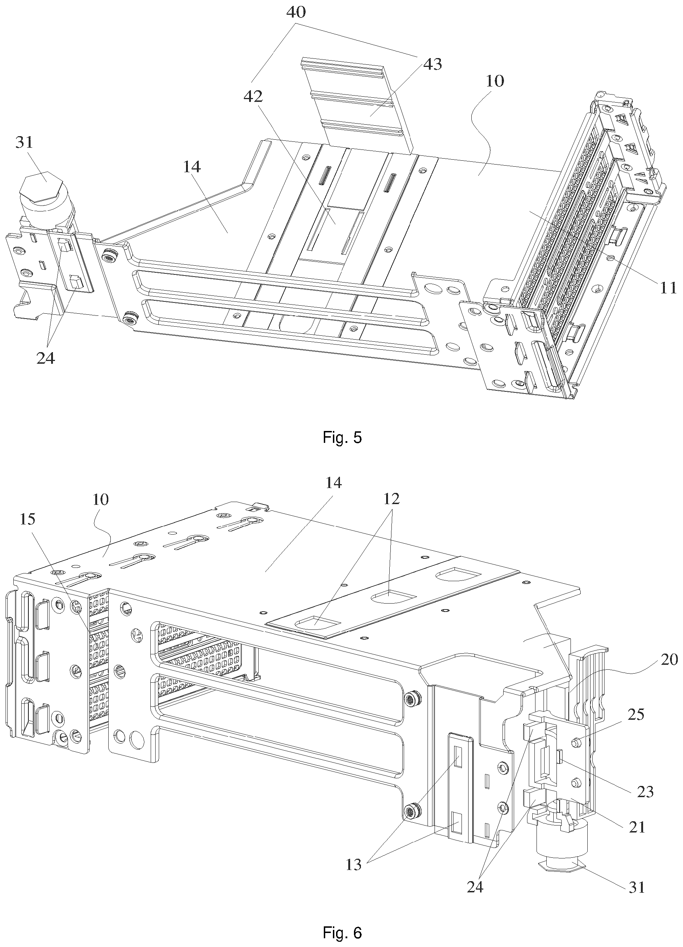

As shown in Figs. 6 to 8, the bracket 10 includes a third mating portion 13, and the locking assembly 20 further includes a locking body 21, a positioning structure 23 and a fourth mating portion 24. The positioning structure 23 is arranged on the locking body 21 to be in limiting fit with the bracket 10. The fourth mating portion 24 is arranged on the locking body 21, and the third mating portion 13 limit fit with the fourth mating portion 24; and/or the locking body 21 includes a connecting hole 211, and the locking assembly 20 further includes a fastener 25, so as to connect the bracket 10 and the locking body 21 by inserting the fastener 25 into the connecting hole 211 and the bracket 10. In this way, by means of the design of the mating between the third mating portion 13 and the fourth mating portion 24, a firm locking between the locking assembly 20 and the bracket 10 can be achieved. The described design of limiting stop can ensure that in a high vibration or moving environment, the locking assembly 20 will not be accidentally disconnected or moved, thereby ensuring the stable connection of the expansion card 60, and reducing data transmission faults caused by unstable connection.

In this embodiment, one of the third mating portion 13 and the fourth mating portion 24 is a protrusion, the other of the third mating portion 13 and the fourth mating portion 24 is a recess, and the protrusion extends into the recess and limit fits with the recess. The connection between the locking assembly 20 and the bracket 10 is achieved by fastener 25 and connecting hole 211. This design allows a user to adjust the position of the locking assembly 20 as needed so as to adapt to expansion cards 60 of different specifications, enhancing the universality and adaptability of the server expansion card fixing mechanism. Meanwhile, by means of introducing an innovative cooperation and connection mechanism between the bracket 10 and the locking assembly 20 of the expansion card fixing mechanism, not only the structural stability and assembling efficiency of the mechanism are improved, but also the cost control is optimized, simplifying the operation flow of users.

In some embodiments, the fastener 25 is a screw or a bolt.

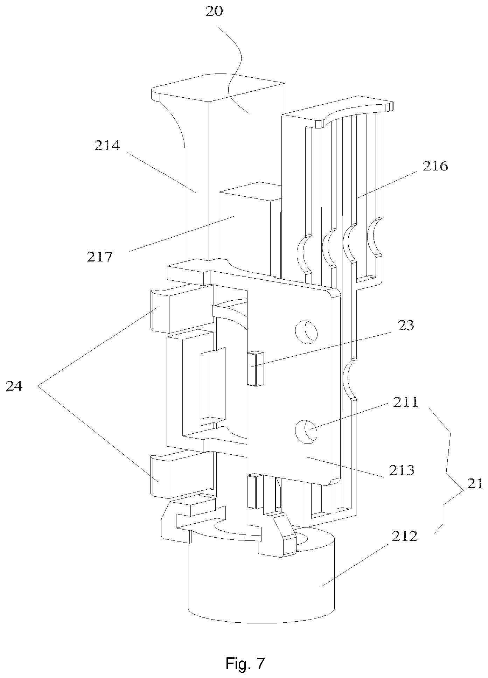

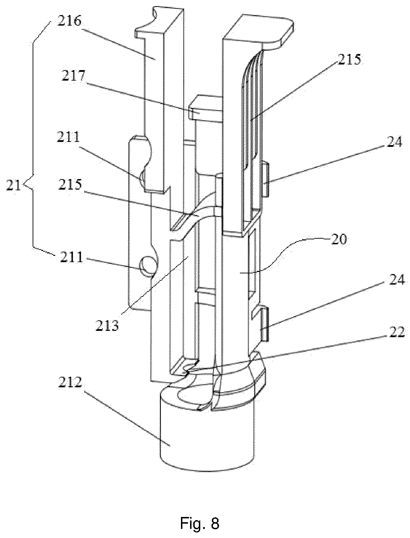

As shown in Figs. 7 and 8, the locking body 21 includes a first handle 216. The locking portion 22 is arranged on a first end of the first handle 216; and the first handle 216 is rotatable so as to drive the locking portion 22 to be in limiting fit with or separated from the positioning portion 31. In this way, the rotatable design of the first handle 216 enables the user to drive the locking portion 22 to cooperate with or separate from the positioning part 31 by means of a simple rotating operation without using additional tools, thereby greatly simplifying the installation and removal process of the expansion card, and improving the maintenance efficiency and the user experience.

As shown in Figs. 7 and 8, the locking body 21 includes a guide sleeve 212, a body portion 213, a second handle 214, and a connecting arm 215. The guide sleeve 212 is movably sleeved outside the positioning portion 31, the body portion 213 is arranged on the guide sleeve 212, the third mating portion 13 and the positioning structure 23 and/or the connecting hole 211 are arranged on the body portion 213. The second handle 214 is arranged on the guide sleeve 212. Two ends of the connecting arm 215 are respectively connected to the first handle 216 and the second handle 214. In the process of operating the second end of the first handle 216 to rotate around the connecting arm 215, the first handle 216 drives the locking portion 22 to move. In this way, the guide sleeve 212 is movably sleeved outside the positioning portion 31, and provides a smooth guide path for the locking body 21, ensuring smooth movement of the locking body 21 during installation and detachment. In addition, by means of the cooperation between the guide sleeve 212 and the positioning portion 31, a high-precision positioning effect is achieved, avoiding a positioning error of an expansion card during fixing, and improving the installation accuracy and efficiency.

In this embodiment, the first handle 216 and the second handle 214 are linked by the connecting arm 215, so that the user can complete the opening and closing movement of the locking assembly only by operating the second handle 214. The connecting arm 215 is located in the middle of the second handle 214. By arranging the locking portion 22 at the end of the second handle 214, the locking and unlocking process is further simplified, and the user can complete the fixing or removal of the expansion card 60 with the minimum operation force and shortest time, thereby greatly improving the convenience of device maintenance and upgrade. Moreover, the arrangement of the locking portion 22 is used in cooperation with the third mating portion 13 and the fourth mating portions 24, so that the expansion card 60 can be fixed quickly and securely in various configurations. The second handle 214 is linked to the first handle 216 by means of the connecting arm 215, so that the position of the locking assembly 20 can be quickly adjusted, and the second protrusion accurately extends into the second recess, thereby achieving a locked state. On the contrary, an unlocking process is also simple and quick, thereby significantly reducing the time cost for maintaining the expansion card 60.

In this embodiment, the arrangement of the third mating portion 13, the positioning structure 23 and the connecting holes 211 on the body portion 213 ensures a firm connection between the locking body 21 and the bracket 10, and can keep the position of the expansion card 60 fixed even in a high vibration environment, thereby improving the system stability and reliability.

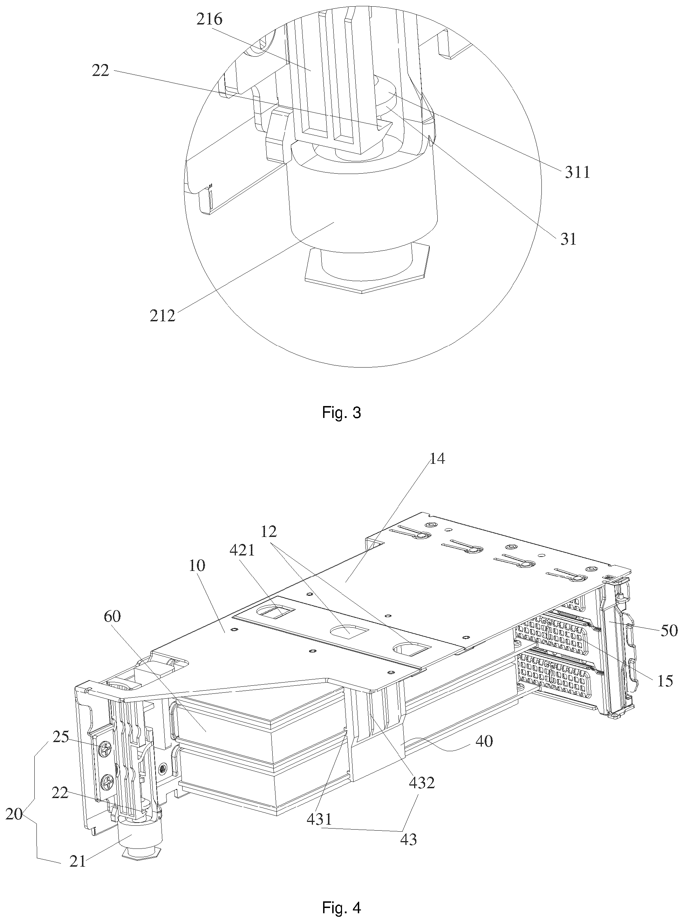

As shown in Fig. 3, the positioning portion 31 has a flange 311, the locking portion 22 has an extension plate 221, and the extension plate 221 is used for extending between the flange 311 and the chassis 30 so as to limit fit with the flange 311. In this way, the design that the extension plate 221 extends between the flange 311 of the positioning portion 31 and the chassis 30 can achieve a limiting and stopping effect in the height direction, ensuring stability of the locking portion 22 in the locked state, avoiding displacement of the expansion card 60 in a long-time use or handling process, and improving the stability of signal transmission of the expansion card 60 and the reliability of the entire system.

As shown in Figs. 7 and 8, the locking assembly 20 further includes a stop structure 217. The stop structure 217 is located between the second handle 214 and the first handle 216; and in the process of the first handle 216 rotating around the connecting arm 215, the stop structure 217 is used for limiting fit with the first handle 216. In this way, the stop structure 217 achieves a limiting stop effect between the first handle 216 and the second handle 214, ensuring precise control of the second handle 214 during rotation, preventing the second handle 214 from excessive rotation and affecting the locking effect of the locking assembly 20, preventing misoperation, ensuring the safety and stability of the expansion card 60 in a fixed state, and reducing the fixing failure or device damage due to improper handle position.

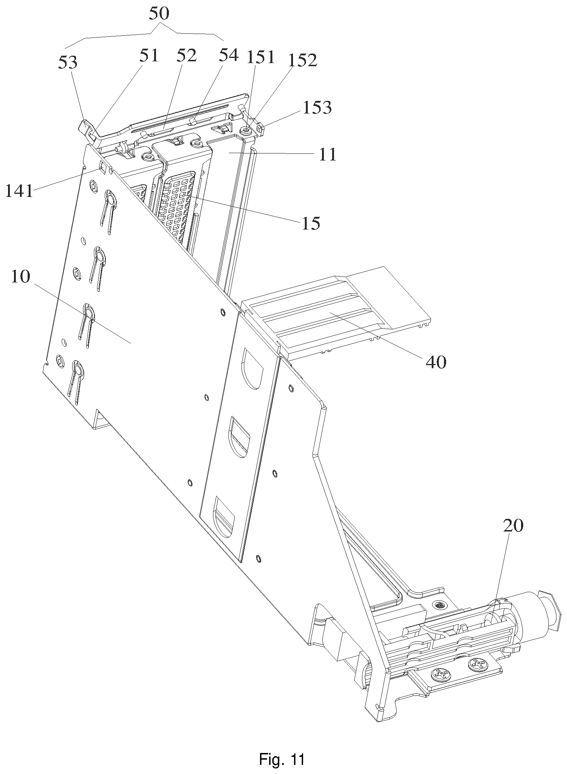

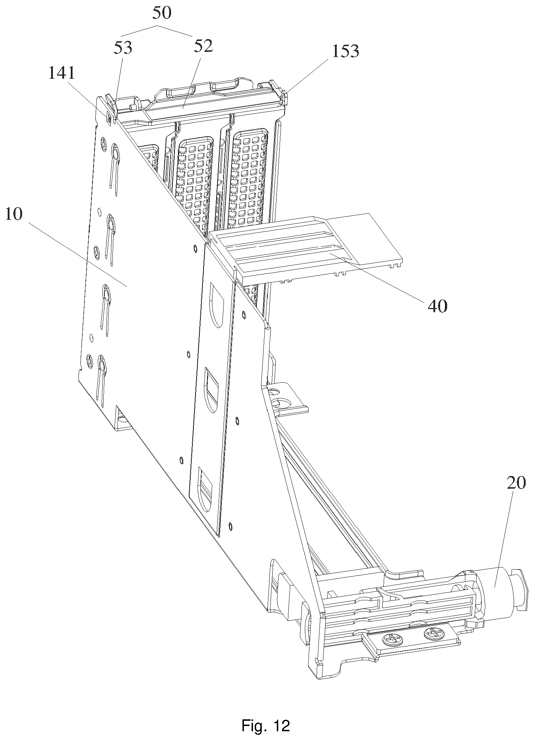

As shown in Figs. 11 and 12, the bracket 10 includes a bracket body 14 and a window body 15 provided on the bracket body 14, and the server expansion card fixing mechanism further includes a retaining plate 80. The retaining plate 80 is arranged on an inner side of the window body 15, and is configured to limit fit with the expansion card. In this way, the retaining plate 80 is arranged inside the window body 15 and directly acts on the expansion card, so that the lateral displacement of the expansion card can be effectively restrained, and the stability of the expansion card inside the server is ensured. Even if the server suffers external vibration or movement, a good electrical connection can be maintained, thereby improving the reliability and stability of the system operation.

As shown in Fig. 11, a first protrusion 152 is arranged on the window body 15, the retaining plate 80 includes a first recess, and the first protrusion 152 extends into the first recess so as to limit fit with the first recess. In this way, the precise fitting of the first protrusion 152 and the first recess enables the retaining plate 80 to be stably mounted on the window body 15, thereby limiting the lateral displacement of the expansion card on the physical layer, and improving the installation precision and stability of the expansion card.

In this embodiment, the limiting stop structure formed between the first protrusion 152 and the first recess enables the assembly of the retaining plate 80 to be intuitive and simple, without requiring complicated alignment or additional fixing tools. The retaining plate 80 only needs to be placed in position, whereupon the first protrusion 152 automatically extends into the first recess to complete the installation of the retaining plate 80, thereby greatly shortening the assembly time.

As shown in Figs. 11-13, the server expansion card fixing mechanism further includes a clamping structure 50, the clamping structure 50 being rotatably connected with the window body 15 or the bracket body 14 for pressing against the retaining plate 80. In this way, the pressing function of the clamping structure 50 directly acts on the retaining plate 80, ensuring that the expansion card is reliably fixed in both the longitudinal direction and the transverse direction inside the server, thereby reducing problems of loosening or displacement of the expansion card caused by server vibration or during transport, and enhancing the overall operating stability of the server system and the continuity of data transmission.

In this embodiment, the design of rotatable connection between the clamping structure 50 and the window body 15 or the bracket body 14 enables maintenance personnel to complete the pressing or releasing of the expansion card simply by operating the clamping structure 50 without using additional tools, greatly simplifying the installation and removal process of the expansion card, and improving the server maintenance and upgrade efficiency.

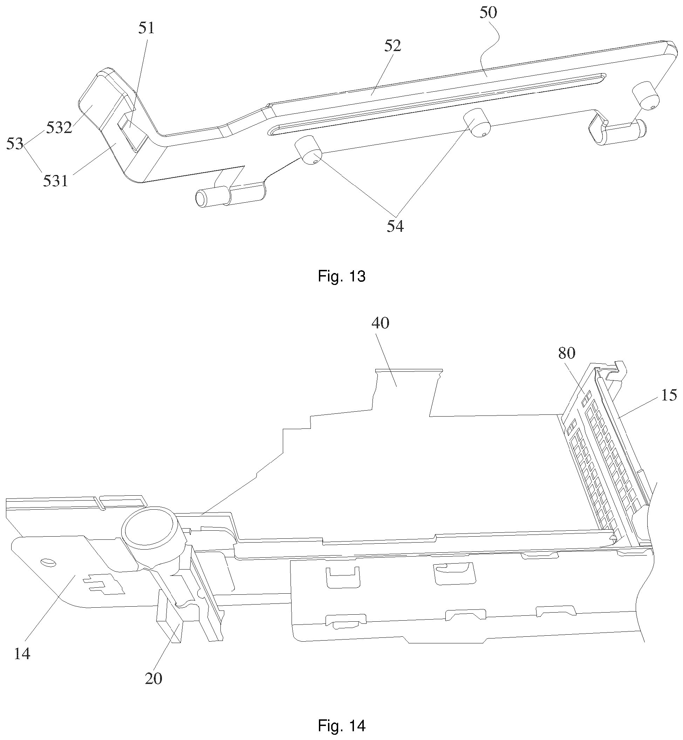

As shown in Figs. 11 and 13, each first protrusion 152 includes a mounting hole 151, and the clamping structure 50 includes a clamping body 55 and a protruding post 54, the protruding post 54 being arranged on the clamping body 55. When the clamping structure 50 presses against the retaining plate 80, the protruding post 54 extends into the mounting hole 151 and is in limiting fit with the mounting hole 151. In this way, the limiting fit between the protruding post 54 and the mounting hole 151 can provide additional physical constraint, and ensure that the position of the clamping structure 50 remains precise and unchanged while pressing against the retaining plate 80, thereby ensuring the stability of the expansion card and the reliability of signal connection.

In this embodiment, the mating design of the protruding post 54 and the mounting hole 151 simplifies the installation and detachment process of the clamping structure 50, no additional fixing piece or tool is required, the clamping structure 50 needs only to be aligned with the mounting hole 151 on the first protrusion 152, the protruding post 54 can automatically extend and lock, making the assembly process more intuitive and efficient.

In this embodiment, the clamping body 55 is in a plate shape, and when the clamping structure 50 presses against the retaining plate 80, two ends of the clamping body 55 respectively limit fit with the bracket body 14 and the window body 15. In this way, the plate-shaped design of the clamping body 55 and the limiting stop between the two ends of the clamping body and the bracket body 14 and the window body 15 not only improve the stability and compatibility of the expansion card fixing mechanism, simplify the assembly process, enhance the heat dissipation and electromagnetic compatibility of the server, but also improve the operation convenience, reduce the manufacturing and maintenance costs, and enhance the security of the server.

In this embodiment, the plate-shaped design of the clamping body 55 makes the clamping body have a large contact area, so that a more stable limiting stop is formed at two ends. This can effectively prevent undesired movement or vibration of the clamping structure 50 during running or transportation of the server, ensure that the fixation of the expansion card and the retaining plate 80 is more stable, and reduce data errors or system failure caused by hardware looseness.

As shown in Fig. 13, the clamping structure 50 includes a third plate body 52 and an extension plate body 53. The third plate body 52 is rotatably connected with the window body 15, and the extension plate body 53 is connected with one end of the third plate body 52 and is arranged at an angle with respect to the third plate body 52. The extension plate body 53 includes a third plate segment 531 and a fourth plate segment 532 which are connected with each other, the fourth plate segment 532 is connected with the third plate body 52 by the third plate segment 531, the third plate segment 531 and the fourth plate segment 532 are arranged at an obtuse angle, and the third plate body 52 and the fourth plate segment 532 are respectively located at two sides of the third plate segment 531; and the sixth mating portion 51 is provided on the third plate segment 531. In this way, by the design of rotatable connection between the third plate body 52 and the window body 15, flexible rotation of the clamping structure 50 is achieved, thereby easily pressing and releasing the expansion card. This design simplifies the installation and removal process of the expansion card, and improves the user operation experience and device maintenance efficiency.

In this embodiment, the mating between a sixth mating portion 51 provided on the third plate segment 531 of the extension plate 53 and a fifth mating portion 141 on the bracket 10 provides precise limiting for the clamping structure 50 when rotating to a locked position. This mechanical stop mechanism ensures the stability and accuracy of the clamping structure 50 in a locked state, and avoids poor contact or hardware damage caused by inaccurate positioning of an expansion card. The clamping structure 50 utilizes the angular arrangement between the extension plate body 53 and the third plate body 52, along with the positional arrangement of the fourth plate segment 532, effectively utilizing the internal space of the expansion card fixing mechanism. This design prevents collisions between the clamping structure 50 and other internal components during rotation, thereby enhancing the compactness and rationality of the device's internal layout.

As shown in Figs. 11 and 12, the bracket body 14 includes a fifth mating portion 141, and the fifth mating portion 141 limits fit with the sixth mating portion 51, thereby providing precise stopping when the clamping structure 50 rotates to a locked position. This mechanical stop mechanism ensures the stability and accuracy of the clamping structure 50 in a locked state, and avoids poor contact or hardware damage caused by inaccurate positioning of an expansion card. The clamping structure 50 utilizes the angular arrangement between the extension plate body 53 and the third plate body 52, along with the positional arrangement of the fourth plate segment 532, effectively utilizing the internal space of the expansion card fixing mechanism. This design prevents collisions between the clamping structure 50 and other internal components during rotation, thereby enhancing the compactness and rationality of the device's internal layout.

As shown in Figs. 11 and 12, the window body 15 is provided with a second protrusion 153, so that when the clamping structure 50 is in the first position, the second protrusion 153 is located on the outer side of the third plate body 52 for limiting fit with the third plate body 52. In this way, when the clamping structure 50 is in the first position (i.e. the pressing state), the second protrusion 153 is located on the outer side of the third plate body 52, so as to form an additional limiting stop for the expansion card by means of contact with the third plate body 52, so that the expansion card can be prevented from being loosened due to vibration or impact during the operation of the server, ensuring the stability of connection between the expansion card and the motherboard, and avoiding a data transmission error or performance degradation caused by a poor connection.

In this embodiment, the second protrusion 153 is arranged to provide a limiting stop, which can ensure that when the expansion card is pressed and fixed, the position of the third plate body 52 does not unnecessarily move, thereby avoiding a misoperation that may occur in the of installation or removal process of the expansion card, protecting the expansion card and related connectors from being damaged, and improving the maintenance efficiency and the reliability of the server.

As shown in Fig. 1, the present invention further provides a server, including a chassis 30, a motherboard 70, an expansion card 60, and a server expansion card fixing mechanism. The chassis 30 includes a positioning portion 31, and the motherboard 70 is arranged in the chassis 30. The server expansion card fixing mechanism is used for mounting the expansion card 60 so as to fix the expansion card 60 on the chassis 30. The server expansion card fixing mechanism is the foregoing server expansion card fixing mechanism.

### Embodiment 2

The server expansion card fixing mechanism in embodiment 2 differs from that in the embodiment 1 in respect of the different structure of the clamping structure 50.

As shown in Figs. 14-17, the clamping structure 50 includes a clamping body 55 and an extension arm 56. The extension arm 56 is arranged on the clamping body 55, and the extension arm 56 extends along the width direction of the retaining plate 80 so as to press against the retaining plate 80. In this way, the extension arm 56 extends along the width direction of the retaining plate 80, and can evenly distribute a pressing force, so as to ensure that the retaining plate 80 and the expansion card are stably supported inside the server, preventing the expansion card from loose or being damaged due to vibration during running or transportation, and improving the system reliability and stability.

In some embodiments, there is one or more extension arms 56, and when there are a plurality of extension arms 56, the plurality of extension arms 56 are arranged at intervals in the width direction of the retaining plate 80 and/or the width direction of the clamping body 55. In this way, the use of a plurality of extension arms 56 allows the pressing force to be distributed more evenly, preventing deformation of the retaining plate 80 or the expansion card caused by single-point pressing, and ensuring the stability of the expansion card inside the server and the reliability of signal connections. Moreover, this arrangement provides greater flexibility in selecting the number of extension arms 56 so as to satisfy different usage requirements and conditions, and also improves the processing flexibility for workers.

In this embodiment, there are four extension arms 56, and the four extension arms 56 are arranged at intervals in the width direction of the retaining plate 80 and in the width direction of the clamping body 55.

It should be noted that the number of the extension arms 56 is not limited thereto, and can be adjusted according to the working condition and usage requirements. In some embodiments, there are two, three, five, six, or more extension arms 56.

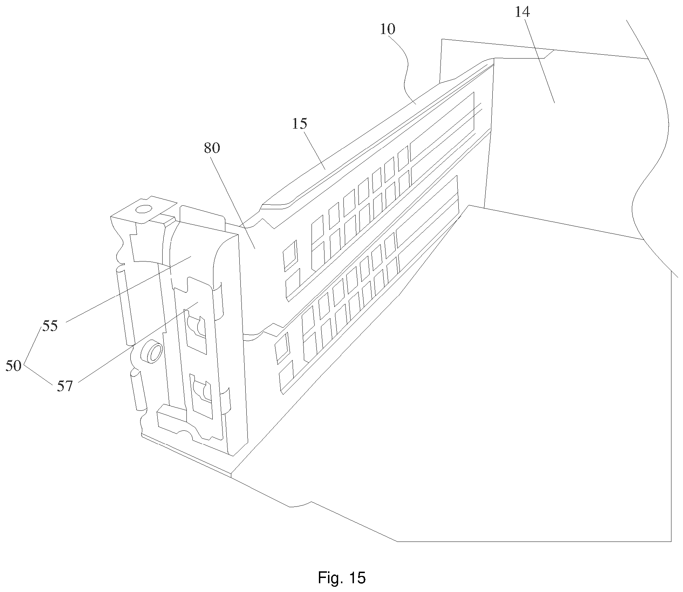

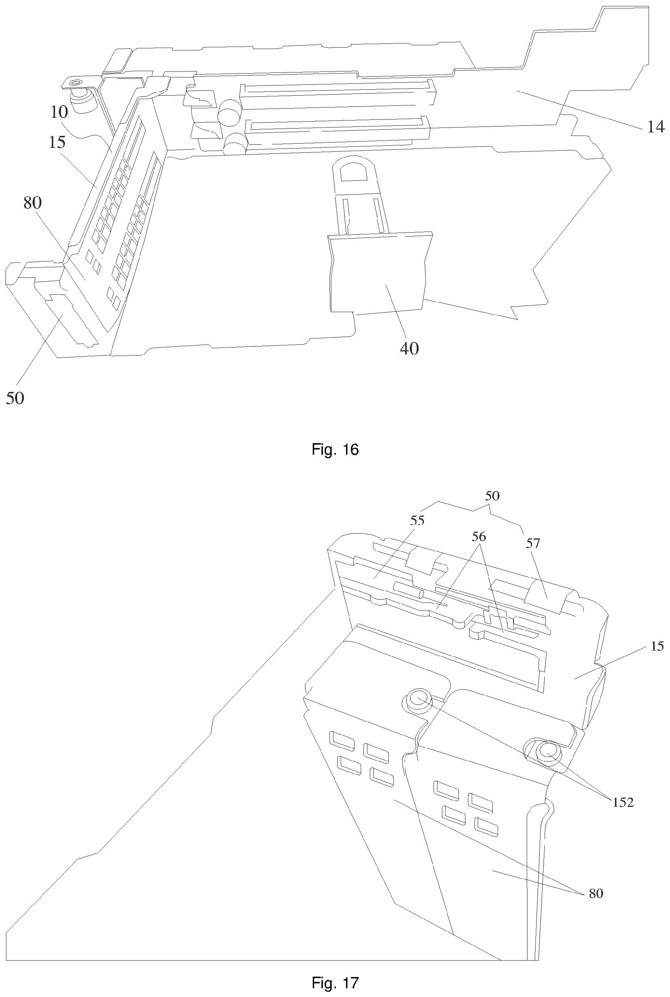

As shown in Figs. 15 and 17, when the clamping structure 50 presses against the retaining plate 80, the surface of the clamping body 55 facing away from the retaining plate 80 forms a mounting surface. The clamping structure 50 further includes metal sheets 57. The metal sheets 57 cover at least a portion of the mounting surface. In this way, the electromagnetic shielding effect of the metal sheets 57 can reduce electromagnetic interference inside the server, protect sensitive electronic components from external electromagnetic fields, and ensure the accuracy of data transmission and the stability of server operation.

Hereinabove, the server expansion card fixing mechanism and the server provided in some embodiments of the present invention are described in detail. The principle and embodiments of the present invention are described herein by applying specific examples, and the illustration of the embodiments above is only used to help understand the method and core ideas of some embodiments of the present invention. It should be noted that, a person of ordinary skill in the art may further make several improvements and modifications to some embodiments of the present invention without departing from the principle of the present invention, and these improvements and modifications also belong to the scope of protection of the claims of the present invention.

## Claims

1. A server expansion card fixing mechanism, comprising:
a bracket (10); and
a fixing structure (40), connected to the bracket (10) or a chassis (30) of a server, wherein the fixing structure (40) comprises at least two slots (431), a card accommodation space (41) is formed among the fixing structure (40), the bracket (10) and the chassis (30), and a size of the card accommodation space (41) is adjustably configured to allow an expansion card to be positioned within one of the at least two slots (431).

2. The server expansion card fixing mechanism as claimed in claim 1, wherein the bracket (10) comprises a plurality of first mating portions (12) disposed at intervals along a preset direction, and the fixing structure (40) comprises:
a first plate body (42), slidably disposed on the bracket (10) along the preset direction, wherein the first plate body (42) is provided with a second mating portion (421), and the second mating portion is selectively engageable with at least one of the plurality of first mating portions (12); and
a second plate body (43), connected with the first plate body (42) and disposed at an angle, the slots (431) being disposed on the second plate body (43).

3. The server expansion card fixing mechanism as claimed in claim 2, wherein the plate body (42) comprises:
a first plate segment (422), wherein the first plate segment comprises two grooves (4221) spaced apart from each other;
a second plate segment (423), located between the two grooves (4221), two ends of the second plate segment (423) being connected with the first plate segment (422); wherein the second mating portion (421) is disposed on the second plate segment (423);
and/or the plate body comprises a first reinforcing rib, the first reinforcing rib is disposed on the second plate segment and spaced apart from the second mating portion.

4. The server expansion card fixing mechanism as claimed in claim 3, wherein the second mating portion (421) has an inclined guide surface (4211); and/or a second reinforcing rib (432) is disposed on the second plate body (43).

5. The server expansion card fixing mechanism as claimed in claim 1, further comprising:
a locking assembly (20), connected with the bracket (10); wherein the locking assembly comprises a movably arranged locking portion (22), and the locking portion (22) is configured to lock or unlock a positioning portion (31) of the chassis (30).

6. The server expansion card fixing mechanism as claimed in claim 5, wherein the bracket (10) comprises a third mating portion (13), and the locking assembly (20) further comprises:
a locking body (21);
a positioning structure (23), wherein the positioning structure (23) is disposed on the locking body (21) so as to be in limiting fit with the bracket (10); and
a fourth mating portions (24), disposed on the locking body (21), wherein the third mating portion (13) engaging with the fourth mating portion (24); and/or the locking body (21) comprises a connecting hole (211), the locking assembly (20) further comprises a fastener which is configured to connect the bracket (10) and the locking body (21) by passing through the connecting hole (211) and the bracket (10).

7. The server expansion card fixing mechanism as claimed in claim 6, wherein the locking body (21) comprises:
a first handle (216), the locking portion (22) is disposed on a first end of the first handle (216);
and the first handle (216) is rotatable so as to drive the locking portion (22) to be in limiting fit with or separated from the positioning portion (31).

8. The server expansion card fixing mechanism as claimed in claim 7, wherein the locking body (21) comprises:
a guide sleeve (212), movably sleeved outside the positioning portion (31);
a body portion (213), disposed on the guide sleeve (212), the third mating portion (13) and the positioning structure (23) and/or the connecting hole (211) are disposed on the body portion (213);
a second handle (214), disposed on the guide sleeve (212); and
a connecting arm (215), two ends of the connecting arm (215) being respectively connected with the first handle (216) and the second handle (214); and
in the process of operating a second end of the first handle (216) to rotate around the connecting arm (215), the first handle (216) drives the locking portion (22) to move.

9. The server expansion card fixing mechanism as claimed in claim 5, wherein the positioning portion (31) comprises a flange (311), the locking portion (22) comprises an extension plate (221), and the extension plate (221) is configured to extend between the flange (311) and the chassis (30), so as to limit fit with the flange (311).

10. The server expansion card fixing mechanism as claimed in claim 8, wherein the locking assembly (20) further comprises:
a stop structure (217), wherein the stop structure (217) is disposed between the second handle (214) and the first handle (216); and in a process of the first handle (216) rotating around the connecting arm (215), the stop structure (217) is configured to limit fit with the first handle (216) .

11. The server expansion card fixing mechanism as claimed in claim 1, wherein the bracket (10) comprises a bracket body (14) and a window body (15) which is disposed on the bracket body (14); and the server expansion card fixing mechanism further comprises:
a retaining plate (80), the retaining plate (80) is disposed on an inner side of the window body (15) and configured to limit fit with an expansion card (60).

12. The server expansion card fixing mechanism as claimed in claim 11, wherein the window body (15) is provided with a first protrusion (152), the retaining plate (80) comprises a first recess, and the first protrusion (152) extends into the first recess to limit fit with the first recess.

13. The server expansion card fixing mechanism as claimed in claim 12, further comprising:
a clamping structure (50), the clamping structure (50) being rotatably connected with the window body (15) or the bracket body (14) for pressing against the retaining plate (80).

14. The server expansion card fixing mechanism as claimed in claim 13, wherein the clamping structure (50) comprises:
a clamping body (55); and
an extension arm (56), disposed on the clamping body (55), wherein the extension arm (56) extends along a width direction of the retaining plate (80), so as to press against the retaining plate (80);
wherein there is one or more extension arms (56), and when there are a plurality of extension arms (56), the plurality of extension arms (56) are disposed at intervals along a width direction of the retaining plate (80) and/or a width direction of the clamping body (55).

15. The server expansion card fixing mechanism as claimed in claim 14, wherein when the clamping structure (50) presses against the retaining plate (80), a surface of the clamping body (55) facing away from the retaining plate (80) forms a mounting surface; and the clamping structure (50) further comprises:
metal sheets (57) covering at least a portion of the mounting surface.

16. The server expansion card fixing mechanism as claimed in claim 13, wherein the first protrusion (152) comprises a mounting hole (151), and the clamping structure (50) comprises:
a clamping body (55); and
a protruding post (54), disposed on the clamping body (55); and
wherein when the clamping structure (50) presses against the retaining plates (80), the protruding post (54) extends into the mounting hole (151) and is in limiting fit with the mounting hole (151).

17. The server expansion card fixing mechanism as claimed in claim 14, wherein the clamping body (55) is in a plate shape, and when the clamping structure (50) presses against the retaining plate (80), two ends of the clamping body (55) respectively limit fit with the bracket body (14) and the window body (15).

18. The server expansion card fixing mechanism as claimed in claim 16, wherein the clamping structure (50) further comprises a third plate body (52) and an extension plate body (53); the third plate body (52) is rotatably connected with the window body (15), and the extension plate body (53) is connected with one end of the third plate body (52) and is disposed at an angle relative to the third plate body (52); the extension plate body (53) comprises a third plate segment (531) and a fourth plate segment (532) connected with each other; the fourth plate segment (532) is connected with the third plate body (52) by the third plate segment (531), the third plate segment (531) and the fourth plate segment (532) are disposed at an obtuse angle, and the third plate body (52) and the fourth plate segment (532) are disposed on two sides of the third plate segment (531)respectively.

19. The server expansion card fixing mechanism as claimed in claim 18, wherein the window body (15) is provided with a second protrusion (153), so that when the clamping structure (50) is in a first position, the second protrusion (153) is located outside the third plate (52) to limit fit with the third plate body (52).

20. A server, comprising:
a chassis (30) comprising a positioning portion (31);
a motherboard (70) arranged in the chassis (30);
an expansion card (60); and
a server expansion card fixing mechanism, configured to mount the expansion card (60) so as to fix the expansion card (60) on the chassis (30); and
wherein the server expansion card fixing mechanism is the server expansion card fixing mechanism as claimed in any one of claims 1 to 19.
